Europäisches Patentamt

European Patent Office

Office européen des brevets

(19)

(11) **EP 1 617 291 A2**

(12) **EUROPEAN PATENT APPLICATION**

(43) Date of publication:
**18.01.2006 Bulletin 2006/03**

(51) Int Cl.:
**G03F 7/20** (2006.01)

(21) Application number: **05014704.0**

(22) Date of filing: **06.07.2005**

(84) Designated Contracting States:
**AT BE BG CH CY CZ DE DK EE ES FI FR GB GR HU IE IS IT LI LT LU LV MC NL PL PT RO SE SI SK TR**
Designated Extension States:
**AL BA HR MK YU**

(30) Priority: **13.07.2004 JP 2004205732**

(71) Applicant: **MATSUSHITA ELECTRIC INDUSTRIAL CO., LTD.**
**Kadoma-shi, Osaka 571-8501 (JP)**

(72) Inventors:
• **Endo, Masayuki**
  **Kishiwada-shi**
  **Osaka 596-0825 (JP)**
• **Sasago, Masaru**
  **Hirakata-shi**
  **Osaka 573-0007 (JP)**

(74) Representative: **Grünecker, Kinkeldey, Stockmair & Schwanhäusser**
**Anwaltssozietät**
**Maximilianstrasse 58**
**80538 München (DE)**

(54) **Immersion exposure liquid and pattern formation method**

(57) An immersion exposure liquid to be provided between a resist film formed on a substrate and a projection lens for increasing the value of a numerical aperture is obtained by adding, to a solvent, a carbonyl group, a sulfonyl group or the like including a polar molecule having higher polarity than water. Thus, the value of the refractive index of the liquid is increased, so as to improve the resolution without increasing load of the projection lens. As a result, a resist pattern can be formed in a good shape.

FIG. 2

## Description

### CROSS-REFERENCE TO RELATED APPLICATIONS

This application claims priority under 35 U.S.C. §119 on Patent Application No. 2004-205732 filed in Japan on July 13, 2004, the entire contents of which are hereby incorporated by reference.

### BACKGROUND OF THE INVENTION

The present invention relates to an immersion exposure liquid and a pattern formation method employing the immersion exposure for use in fabrication process or the like for semiconductor devices.

In accordance with the increased degree of integration of semiconductor integrated circuits and downsizing of semiconductor devices, there are increasing demands for further rapid development of lithography technique. Currently, pattern formation is carried out through photolithography using exposing light of a mercury lamp, KrF excimer laser, ArF excimer laser or the like, and use of $F_2$ laser lasing at a shorter wavelength is being examined. However, since there remain a large number of problems in exposure systems and resist materials, photolithography using exposing light of a shorter wavelength has not been put to practical use.

In these circumstances, immersion lithography has been recently proposed for realizing further refinement of patterns by using conventional exposing light (for example, see M. Switkes and M. Rothschild, "Immersion lithography at 157 nm", J. Vac. Sci. Technol., Vol. B19, p. 2353 (2001)).

In the immersion lithography, a region in an exposure system sandwiched between a projection lens and a resist film formed on a wafer is filled with a liquid having a refractive index **n** (whereas n > 1) and therefore, the NA (numerical aperture) of the exposure system has a value **n·NA**. As a result, the resolution of the resist film can be improved.

Now, a conventional pattern formation method employing the immersion lithography will be described with reference to FIGS. **10A** through **10D**.

First, a positive chemically amplified resist material having the following composition is prepared:

| | |
|---|---|
| Base polymer: poly((norbornene-5-methylene-t-butylcarboxylate) (50 mol%) - maleic anhydride) (50 mol%)) | 2 g |
| Acid generator: triphenylsulfonium triflate | 0.06 g |
| Quencher: triethanolamine | 0.002 g |
| Solvent: propylene glycol monomethyl ether acetate | 20 g |

Next, as shown in FIG. **10A,** the aforementioned chemically amplified resist material is applied on a substrate **1** so as to form a resist film **2** with a thickness of 0.35 $\mu$m.

Then, as shown in FIG. **10B,** with water **3** for immersion exposure having a refractive index of 1.44 provided between the resist film **2** and a projection lens (not shown), pattern exposure is carried out by irradiating the resist film **2** with exposing light **4** of ArF excimer laser with NA of 0.68 through a mask **5.**

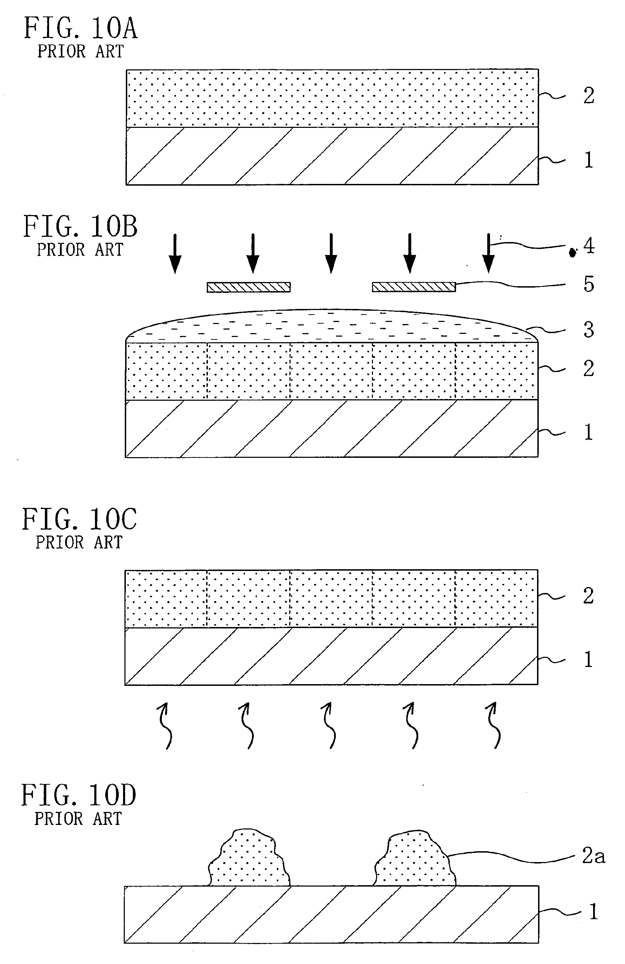

After the pattern exposure, as shown in FIG. **10C,** the resist film **2** is baked with a hot plate at a temperature of 105°C for 60 seconds, and the resultant resist film is developed with a tetramethylammonium hydroxide developer in a concentration of 0.26 N. In this manner, a resist pattern **2a** made of an unexposed portion of the resist film **2** is formed as shown in FIG. **10D.**

### SUMMARY OF THE INVENTION

As shown in FIG. **10D,** however, the resist pattern **2a** formed by the conventional pattern formation method is in a defective shape.

The present inventors have variously examined the reason why the resist pattern formed by the conventional immersion lithography is in a defective shape, resulting in finding the following: The water **3** used as the immersion exposure liquid has an insufficient refractive index for achieving further higher resolution, and hence, the pattern is formed in a defective shape in the vicinity of the critical resolution.

Accordingly, when the resist pattern is in a defective shape owing to the exposure in the vicinity of the critical resolution and the resist pattern in such a defective shape is used for etching, a pattern obtained in an etched film is also in a defective shape. As a result, the productivity and the yield of fabrication process for semiconductor devices are lowered.

In consideration of the aforementioned conventional problem, an object of the invention is preventing a pattern shape failure by improving the resolution attained in the immersion lithography.

In order to achieve the object, according to the invention, the polarization of an immersion exposure liquid is improved so as to increase the refractive index of the liquid, and thus, the resolution attained in the immersion lithography is improved.

In general, the resolution of exposure is represented by the following Formula 1:

Formula 1:

$$\text{Resolution} = K1 \cdot \lambda / NA$$

wherein **K1** is a constant determined depending upon process conditions and an exposure optical system, $\lambda$ is the wavelength of exposing light and **NA** is a numerical aperture. Accordingly, it is understood from Formula 1 that the value of the resolution itself is reduced, namely, the resolution is improved, by reducing the wavelength of exposing light or increasing the numerical aperture.

In the exposure method designated as the immersion lithography, a space between an exposure lens and a resist film is filled with a material having a refractive index different from that of the air, such as a liquid like water in general, so as to increase the value of the numerical aperture of an exposure system. In this manner, high resolution can be attained without reducing the wavelength of exposing light.

The present inventors have found through various examinations that the refractive index of an immersion exposure liquid can be increased by polarizing the immersion exposure liquid or adding a compound with high polarity to the immersion exposure liquid.

Specifically, in a polarized compound, electrons included therein are present in a localized state, and therefore, when light passes through the polarized compound, waves of the light are influenced by the localized electrons and are refracted in accordance with the degree of the localization of the electrons. In other words, when the immersion exposure liquid is polarized, the value of the refractive index is increased, and hence, the value of the numerical aperture **NA** of Formula 1 is also substantially increased, resulting in improving the resolution of a pattern. The present invention was devised on the basis of this finding and is specifically practiced as follows:

The first immersion exposure liquid of this invention is to be provided between a resist film formed on a substrate and an exposure lens in immersion exposure for increasing a value of a numerical aperture, and includes a solvent; and a polar molecule having higher polarity than the solvent.

In the first immersion exposure liquid, the refractive index of the liquid is increased owing to localization of electrons caused by the polar molecule included therein as compared with the case where the liquid includes the solvent alone. The increase of the refractive index increases the value of a numerical aperture, so as to improve the resolution attained in the immersion exposure. As a result, a pattern shape failure can be prevented.

The second immersion exposure liquid of this invention is to be provided between a resist film formed on a substrate and an exposure lens in immersion exposure for increasing a value of a numerical aperture, and includes a solvent; and a polar polymer molecule having higher polarity than the solvent.

In the second immersion exposure liquid, the refractive index of the liquid is increased owing to localization of electrons caused by the polar polymer molecule included therein as compared with the case where the liquid includes the solvent alone. The increase of the refractive index increases the value of a numerical aperture, so as to improve the resolution attained in the immersion exposure. As a result, a pattern shape failure can be prevented.

The third immersion exposure liquid of this invention is to be provided between a resist film formed on a substrate and an exposure lens in immersion exposure for increasing a value of a numerical aperture, and includes a solvent; and a nano magnetic substance.

In the third immersion exposure liquid, since electrons included in the solvent are localized and polarized by a magnetic field generated by the nano magnetic substance included in the liquid, the refractive index of the liquid is increased as compared with the case where the liquid includes the solvent alone. The increase of the refractive index increases the value of a numerical aperture, so as to improve the resolution attained in the immersion exposure. As a result, a pattern shape failure can be prevented.

The first pattern formation method of this invention includes the steps of forming a resist film on a substrate; performing pattern exposure by selectively irradiating the resist film with exposing light with a liquid provided on the resist film; and forming a resist pattern by developing the resist film after the pattern exposure, and an electric field is applied to the liquid in the step of performing pattern exposure.

In the first pattern formation method, polarization is caused in the liquid by the applied electric field in the step of performing pattern exposure, and hence electrons are localized by the polarization and the refractive index of the liquid is increased. The increase of the refractive index increases the value of a numerical aperture, and therefore, the resolution attained in the immersion exposure is improved. As a result, a pattern shape failure can be prevented.

The second pattern formation method of this invention includes the steps of forming a resist film on a substrate; performing pattern exposure by selectively irradiating the resist film with exposing light with a liquid provided on the resist film; and forming a resist pattern by developing the resist film after the pattern exposure, and a magnetic field is applied to the liquid in the step of performing pattern exposure.

In the second pattern formation method, polarization is caused in the liquid by the applied magnetic field in the step of performing pattern exposure, and hence the refractive index of the liquid is increased by the polarization. The increase of the refractive index increases the value of a numerical aperture, and therefore, the resolution attained in the immersion exposure is improved. As a result, a pattern shape failure can be prevented.

The third pattern formation method of this invention includes the steps of forming a resist film on a substrate; performing pattern exposure by selectively irradiating the resist film with exposing light with a liquid, which includes a solvent and a polar molecule having higher polarity than the solvent, provided on the resist film; and forming a resist pattern by developing the resist film after the pattern exposure.

In the third pattern formation method, the refractive index of the liquid is increased by polarization caused by the polar molecule included in the liquid as compared with the case where the liquid includes the solvent alone. The increase of the refractive index increases the value of a numerical aperture, and therefore, the resolution attained in the immersion exposure is improved. As a result, a pattern shape failure can be prevented.

The fourth pattern formation method of this invention includes the steps of forming a resist film on a substrate; performing pattern exposure by selectively irradiating the resist film with exposing light with a liquid, which includes a solvent and a polar polymer molecule having higher polarity than the solvent, provided on the resist film; and forming a resist pattern by developing the resist film after the pattern exposure.

In the fourth pattern formation method, the refractive index of the liquid is increased by polarization caused by the polar polymer molecule included in the liquid as compared with the case where the liquid includes the solvent alone. The increase of the refractive index increases the value of a numerical aperture, and therefore, the resolution attained in the immersion exposure is improved. As a result, a pattern shape failure can be prevented.

The fifth pattern formation method of this invention includes the steps of forming a resist film on a substrate; performing pattern exposure by selectively irradiating the resist film with exposing light with a liquid, which includes a solvent and a nano magnetic substance, provided on the resist film; and forming a resist pattern by developing the resist film after the pattern exposure.

In the fifth pattern formation method, polarization is caused in the solvent by a magnetic field generated by the nano magnetic substance included in the liquid, and hence, the refractive index of the liquid is increased by the polarization as compared with the case where the liquid includes the solvent alone. The increase of the refractive index increases the value of a numerical aperture, and therefore, the resolution attained in the immersion exposure is improved. As a result, a pattern shape failure can be prevented.

The content of the polar molecule, the polar polymer molecule or the nano magnetic substance in the immersion exposure liquid is preferably approximately not less than 0.1 wt% and not more than 10 wt%, which does not limit the invention.

In the first immersion exposure liquid or the third pattern formation method, the polar molecule can be a molecule having a carbonyl group, a sulfonyl group, a lactone group or activated hydrogen. For example, the molecule having a carbonyl group may be acrylic acid, phosphoric acid or acetic acid, the molecule having a sulfonyl group may be styrene sulfonic acid, the molecule having a lactone group may be $\gamma$-butyrolactone and the molecule having activated hydrogen may be hydrochloric acid.

In the second immersion exposure liquid or the fourth pattern formation method, the polar polymer molecule can be a polymer molecule having a carbonyl group, a sulfonyl group or a lactone group.

For example, the polymer molecule having a carbonyl group may be poly(acrylic acid), the polymer molecule having a sulfonyl group may be polystyrene sulfonic acid and the polymer molecule having a lactone group may be polymevalonic lactone methacrylate.

In the third immersion exposure liquid or the fifth pattern formation method, the nano magnetic substance can be a magnetic disk dot with a diameter of 1 $\mu$m or less or a magnetic wire with a line width of 1 $\mu$m or less. When a nano magnetic substance with such a size is used, owing to its fineness, the magnetic substance can be prevented from causing such a failure that it is transferred onto a resist. It is noted that the magnetic wire may have a length of approximately several $\mu$m.

In each of the first through third immersion exposure liquids, the solvent can be water or perfluoropolyether.

In each of the first through fifth pattern formation methods, the solvent can be water or perfluoropolyether.

In each of the first through fifth pattern formation methods, the exposing light can be KrF excimer laser, $Xe_2$ laser, ArF excimer laser, $F_2$ laser, KrAr laser or $Ar_2$ laser.

**BRIEF DESCRIPTION OF THE DRAWINGS**

FIGS. **1A, 1B, 1C** and **1D** are cross-sectional views for showing procedures in a pattern formation method using an immersion exposure liquid according to Embodiment 1 of the invention;

FIG. **2** is a graph for showing the relationship between the concentration of hydrochloric acid in the immersion exposure liquid of Embodiment 1 and the refractive index of the liquid;

FIGS. **3A, 3B, 3C** and **3D** are cross-sectional views for showing procedures in a pattern formation method using an immersion exposure liquid according to Embodiment 2 of the invention;

FIG. **4A** is a graph for showing the relationship between the concentration of poly(acrylic acid) in the immersion exposure liquid of Embodiment 2 and the refractive index of the liquid, and FIG. **4B** is a schematic cross-sectional view for showing a state where a carbonyl group or a sulfonyl group of a compound added to the immersion exposure liquid of Embodiment 2 is polarized in the liquid;

FIGS. **5A, 5B, 5C** and **5D** are cross-sectional views for showing procedures in a pattern formation method using an immersion exposure liquid according to Embodiment 3 of the invention;

FIGS. **6A, 6B, 6C** and **6D** are cross-sectional views for showing procedures in a pattern formation method according to Embodiment 4 of the invention;

FIG. **7** is a graph for showing the relationship between the strength of an electric field applied to an immersion exposure liquid and the refractive index of the liquid in the pattern formation method of Embodiment 4;

FIGS. **8A, 8B, 8C** and **8D** are cross-sectional views for showing procedures in a pattern formation method according to Embodiment 5 of the invention;

FIG. **9** is a graph for showing the relationship between the strength (magnetic flux density) of a magnetic field applied to an immersion exposure liquid and the refractive index of the liquid in the pattern formation method of Embodiment 5; and

FIGS. **10A, 10B, 10C** and **10D** are cross-sectional views for showing procedures in a conventional pattern formation method employing the immersion lithography.

**DETAILED DESCRIPTION OF THE INVENTION**

EMBODIMENT 1

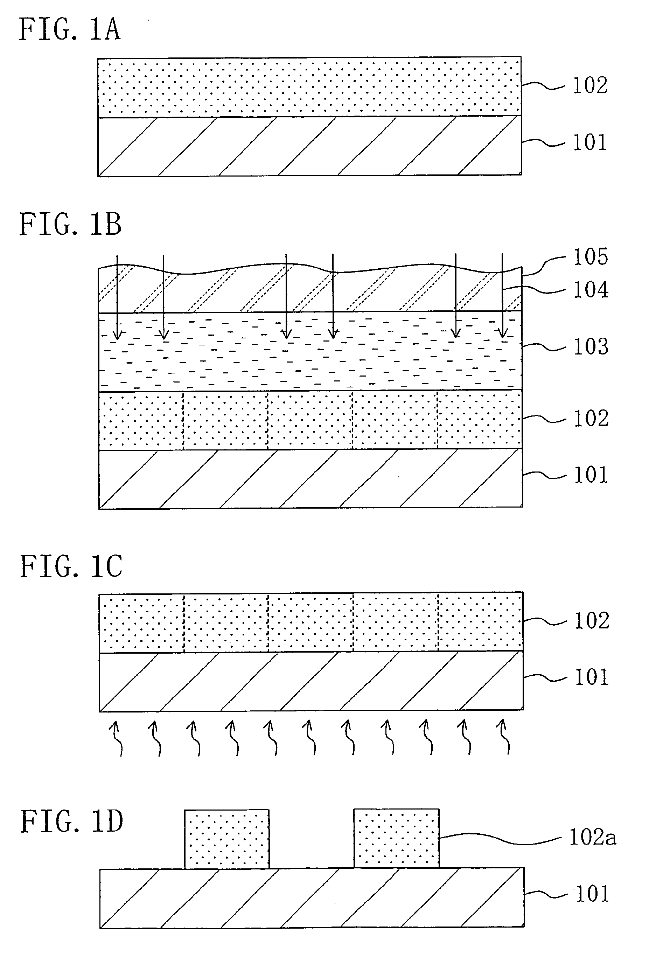

Now, a pattern formation method according to Embodiment 1 of the invention will be described with reference to FIGS. **1A** through **1D**.

First, a positive chemically amplified resist material having the following composition is prepared:

| | |
|---|---|
| Base polymer: poly((norbornene-5-methylene-t-butylcarboxylate) (50 mol%) - (maleic anhydride) (50 mol%)) | 2 g |
| Acid generator: triphenylsulfonium triflate | 0.06 g |
| Quencher: triethanolamine | 0.002 g |
| Solvent: propylene glycol monomethyl ether acetate | 20 g |

Next, as shown in FIG. **1A,** the aforementioned chemically amplified resist material is applied on a substrate **101** so as to form a resist film **102** with a thickness of 0.35 $\mu$m.

Then, as shown in FIG. **1B,** an immersion exposure liquid **103** obtained by adding, to water, hydrochloric acid (HCl), that is, a compound having activated hydrogen with higher polarity than water, in a concentration of 5 wt% and having a refractive index of 1.59 is provided between the resist film **102** and a projection lens **105**. Under this condition, pattern exposure is carried out by irradiating the resist film **102** through a mask (not shown) with exposing light **104** of ArF excimer laser with NA of 0.68.

After the pattern exposure, as shown in FIG. **1C,** the resist film **102** is baked with a hot plate at a temperature of 105°C for 60 seconds, and thereafter, the resultant resist film **102** is developed with a tetramethylammonium hydroxide developer in a concentration of 0.26 N. In this manner, a resist pattern **102a** made of an unexposed portion of the resist film **102** and having a line width of 0.07 $\mu$m is formed in a good shape as shown in FIG. **1D.**

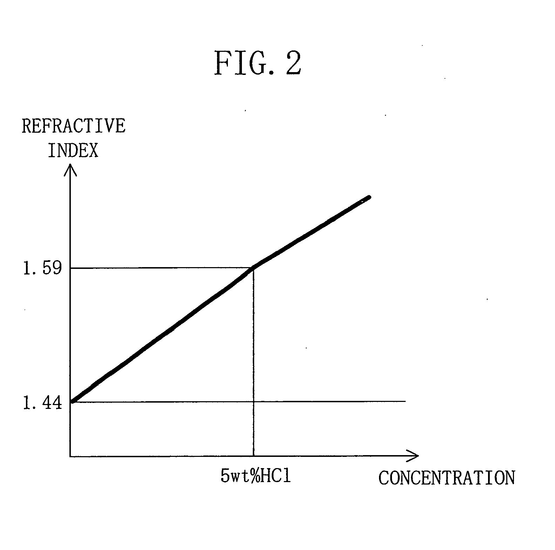

In this manner, according to the pattern formation method of Embodiment 1, since the immersion exposure liquid **103** includes hydrochloric acid having activated hydrogen with higher polarity than water, the polarity of the liquid **103** is higher than that of water. In other words, the polarization of the liquid **103** is increased, and hence, as shown in a graph of FIG. 2, the value of the refractive index of the liquid **103** is increased. Therefore, the value of the numerical aperture of the exposure system is increased, so that the resist pattern **102a** can be formed in a good shape through the immersion lithography.

The concentration of the hydrochloric acid in the immersion exposure liquid **103** can be not less than 0.1 wt% and not more than 10 wt%, which does not limit the invention.

EMBODIMENT 2

Now, a pattern formation method according to Embodiment 2 of the invention will be described with reference to FIGS. **3A** through **3D**.

First, a positive chemically amplified resist material having the following composition is prepared:

| | |
|---|---|
| Base polymer: poly((norbomene-5-methylene-t-butylcarboxylate) (50 mol%) — (maleic anhydride) (50 mol%)) | 2 g |
| Acid generator: triphenylsulfonium triflate | 0.06 g |
| Quencher: triethanolamine | 0.002 g |
| Solvent: propylene glycol monomethyl ether acetate | 20 g |

Next, as shown in FIG. **3A**, the aforementioned chemically amplified resist material is applied on a substrate **201** so as to form a resist film **202** with a thickness of 0.3 $\mu$m.

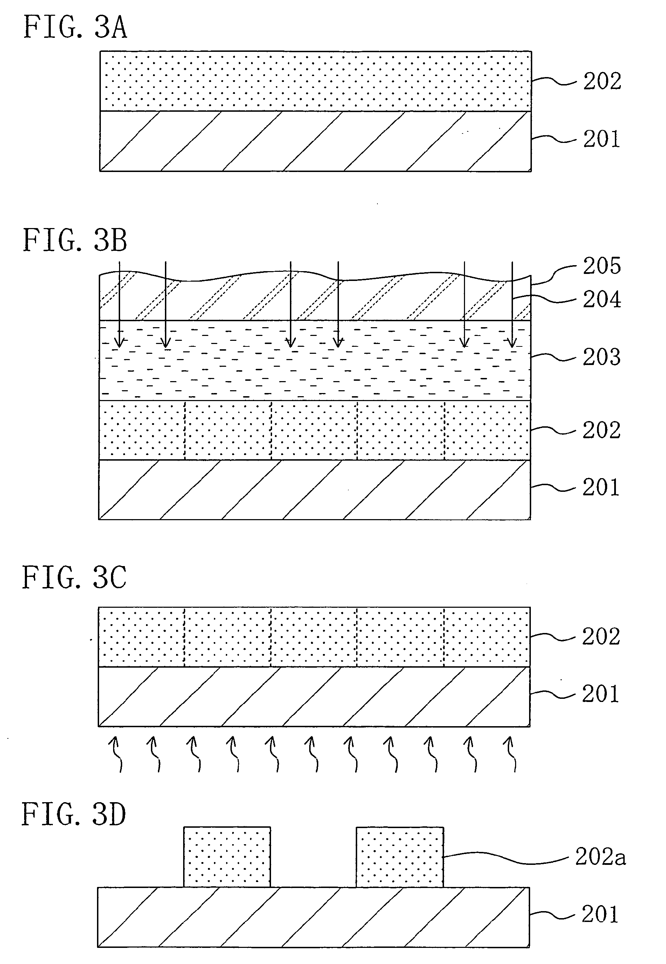

Then, as shown in FIG. **3B**, an immersion liquid **203** obtained by adding, to water, poly(acrylic acid) {-(CH$_2$-CH-COOH)-$_n$} (having a molecular weight of approximately 2500), that is, a compound having a carbonyl group with higher polarity than water, in a concentration of 4 wt% and having a refractive index of 1.62 is provided between the resist film **202** and a projection lens **205**. Under this condition, pattern exposure is carried out by irradiating the resist film **202** through a mask (not shown) with exposing light **204** of ArF excimer laser with NA of 0.68.

After the pattern exposure, as shown in FIG. **3C**, the resist film **202** is baked with a hot plate at a temperature of 105°C for 60 seconds, and thereafter, the resultant resist film **202** is developed with a tetramethylammonium hydroxide developer in a concentration of 0.26 N. In this manner, a resist pattern **202a** made of an unexposed portion of the resist film **202** and having a line width of 0.07 $\mu$m is formed in a good shape as shown in FIG. **3D.**

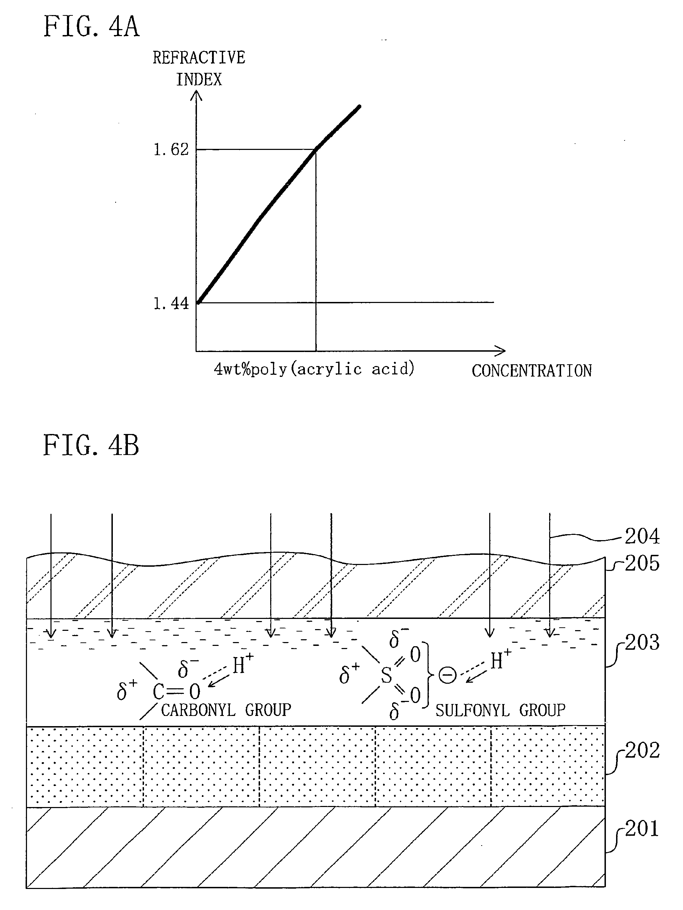

In this manner, according to the pattern formation method of Embodiment 2, since the immersion exposure liquid **203** includes poly(acrylic acid) having a carbonyl group with higher polarity than water, the polarity of the liquid **203** is higher than that of water. In other words, the polarization of the liquid **203** is increased, and hence, as shown in a graph of FIG. **4A,** the value of the refractive index of the liquid **203** is increased. Therefore, the value of the numerical aperture of the exposure system is increased, so that the resist pattern **202a** can be formed in a good shape through the immersion lithography.

FIG. **4B** schematically shows a state where the polarization of the liquid **203** is increased so as to increase the value of the refractive index thereof when a carbonyl group or a sulfonyl group having higher polarity than water is added to the liquid **203**. As shown in FIG. **4B**, an oxygen atom included in the carbonyl group or the sulfonyl group has higher electronegativity than a carbon atom included in the carbonyl group or a sulfur atom included in the sulfonyl group, and therefore, the polarization larger than that of water is caused in the liquid **203**. As a result, when the light passes through the polarized compound, the waves of the light are influenced by electrons localized through the polarization, and hence, the refractive index is increased.

Apart from hydrochloric acid having activated hydrogen and poly(acrylic acid) having a carbonyl group, examples of the compound with higher polarity than water are acetic acid, acrylic acid or phosphoric acid having a carbonyl group; sulfonic acid or polystyrene sulfonic acid having a sulfonyl group; and $\gamma$-butyrolactone or polymevalonic lactone methacrylate having a lactone group.

EMBODIMENT 3

Now, a pattern formation method according to Embodiment 3 of the invention will be described with reference to FIGS. **5A** through **5D**.

First, a positive chemically amplified resist material having the following composition is prepared:

| | |
|---|---|
| Base polymer: poly((norbornene-5-methylene-t-butylcarboxylate) (50 mol%) - (maleic anhydride) (50 mol%)) | 2 g |
| Acid generator: triphenylsulfonium triflate | 0.06 g |
| Quencher: triethanolamine | 0.002 g |

Table continued

| Solvent: propylene glycol monomethyl ether acetate | 20 g |

Next, as shown in FIG. **5A**, the aforementioned chemically amplified resist material is applied on a substrate **301** so as to form a resist film **302** with a thickness of 0.35 $\mu$m.

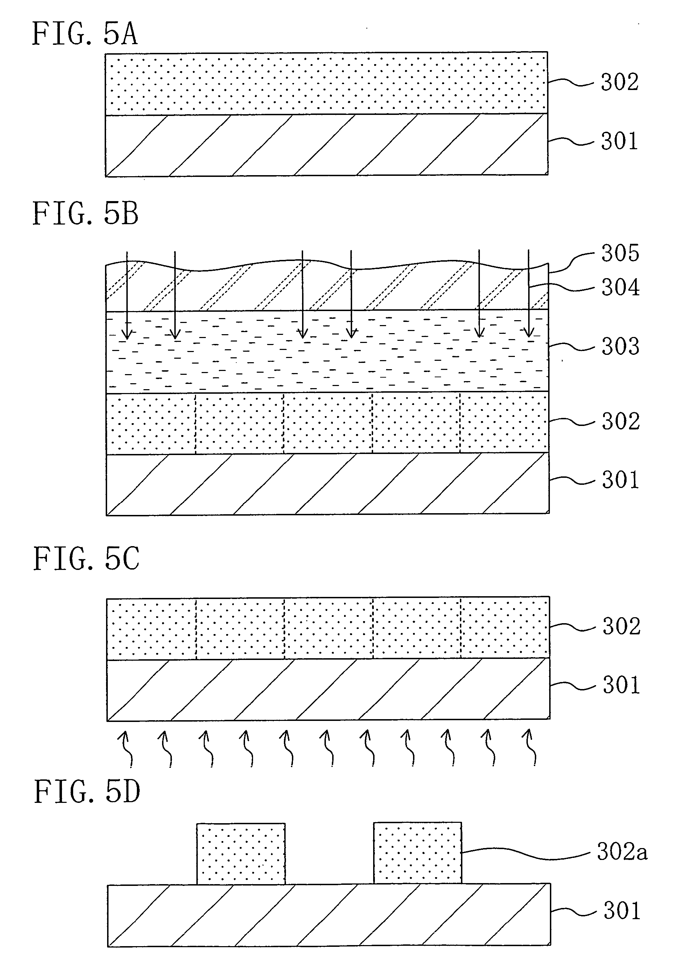

Then, as shown in FIG. **5B**, an immersion exposure liquid **303** obtained by adding, to water, magnetic disk dots made of an alloy of nickel (Ni) and iron (Fe) and having a diameter of approximately 500 nm in a concentration of 2 wt% is provided between the resist film **302** and a projection lens **305**. Under this condition, pattern exposure is carried out by irradiating the resist film **302** through a mask (not shown) with exposing light **304** of ArF excimer laser with NA of 0.68.

After the pattern exposure, as shown in FIG. **5C**, the resist film **302** is baked with a hot plate at a temperature of 105°C for 60 seconds, and thereafter, the resultant resist film **302** is developed with a tetramethylammonium hydroxide developer in a concentration of 0.26 N. In this manner, a resist pattern **302a** made of an unexposed portion of the resist film **302** and having a line width of 0.07 $\mu$m is formed in a good shape as shown in FIG. **5D**.

In this manner, according to the pattern formation method of Embodiment 3, since the immersion exposure liquid **303** includes the magnetic disk dots, that is, the so-called nano magnetic substance, the polarity of the liquid **303** is higher than that of water. In other words, the polarization of the liquid **303** is increased, and hence, the value of the refractive index of the liquid **303** is increased. Therefore, the value of the numerical aperture of the exposure system is increased, so that the resist pattern **302a** can be formed in a good shape through the immersion lithography.

As the nano magnetic substance, a magnetic wire having a line width of, for example, 1 $\mu$m or less and a length of several $\mu$m or less can be used instead of the magnetic disk dot.

EMBODIMENT 4

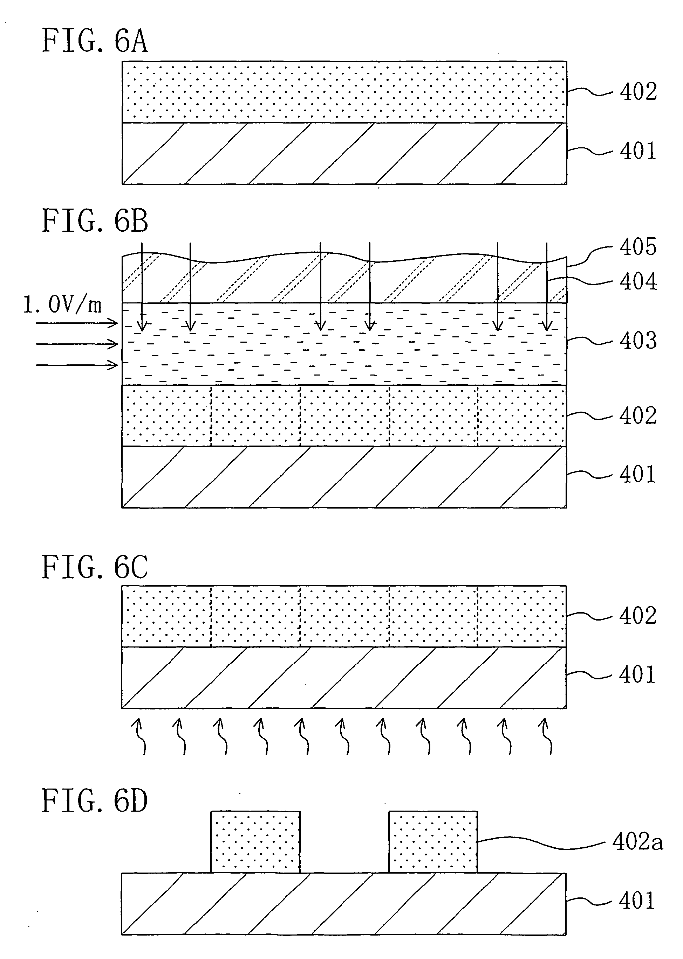

Now, a pattern formation method according to Embodiment 4 of the invention will be described with reference to FIGS. **6A** through **6D**.

First, a positive chemically amplified resist material having the following composition is prepared:

| Base polymer: poly((norbornene-5-methylene-t-butylcarboxylate) (50 mol%) - (maleic anhydride) (50 mol%)) | 2 g |
| Acid generator: triphenylsulfonium triflate | 0.06 g |
| Quencher: triethanolamine | 0.002 g |
| Solvent: propylene glycol monomethyl ether acetate | 20 g |

Next, as shown in FIG. **6A**, the aforementioned chemically amplified resist material is applied on a substrate **401** so as to form a resist film **402** with a thickness of 0.35 $\mu$m.

Then, as shown in FIG. **6B**, an immersion exposure liquid **403** of water is provided between the resist film **402** and a projection lens **405**. At this point, an electric field with a strength of, for example, approximately 1.0 V/m is applied between the resist film **403** and the projection lens **405**. Under this condition, pattern exposure is carried out by irradiating the resist film **402** through a mask (not shown) with exposing light **404** of ArF excimer laser with NA of 0.68.

After the pattern exposure, as shown in FIG. **6C**, the resist film **402** is baked with a hot plate at a temperature of 105°C for 60 seconds, and thereafter, the resultant resist film **402** is developed with a tetramethylammonium hydroxide developer in a concentration of 0.26 N. In this manner, a resist pattern **402a** made of an unexposed portion of the resist film **402** and having a line width of 0.07 $\mu$m is formed in a good shape as shown in FIG. **6D**.

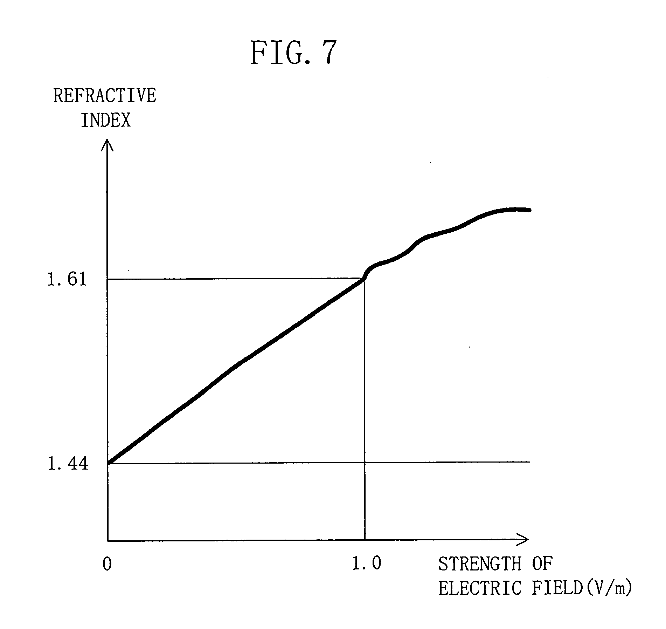

FIG. 7 shows the relationship between the strength of the electric field applied to the immersion exposure liquid **403** and the refractive index of the liquid.

In this manner, according to the pattern formation method of Embodiment 4, since the immersion exposure liquid **403** is put in the electric field during the exposure, the polarity of the liquid **403** is higher than that of the water not put in the electric field. In other words, the polarization of the liquid **403** is increased, and hence, the value of the refractive index of the liquid **403** is increased. Therefore, the value of the numerical aperture of the exposure system is increased, so that the resist pattern **402a** can be formed in a good shape through the immersion lithography.

The strength of the applied electric field can be not less than 0.0001 V/m and not more than 10.0 V/m, which does not limit the invention.

EMBODIMENT 5

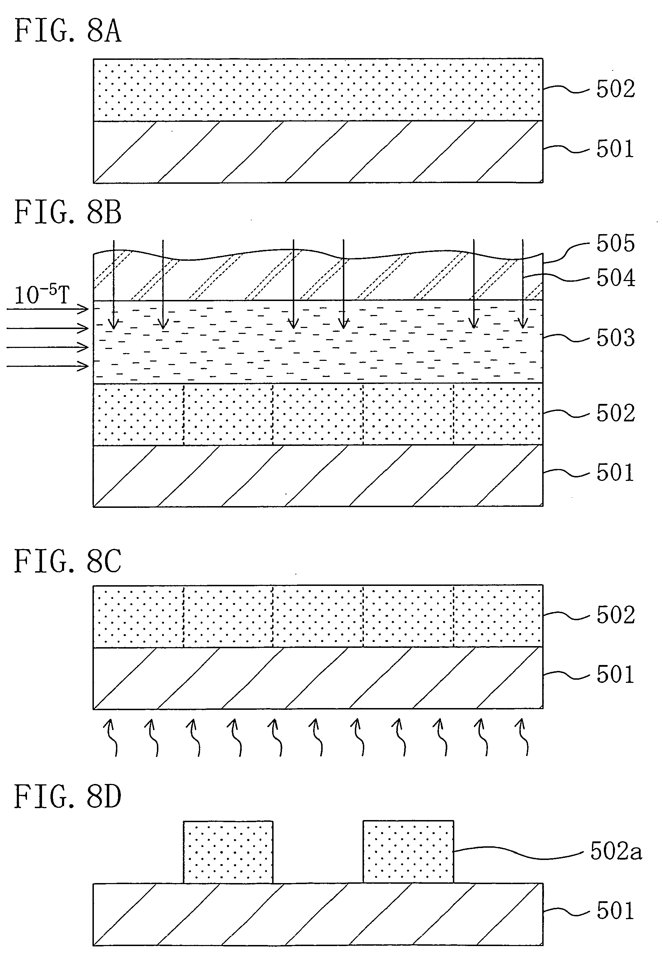

Now, a pattern formation method according to Embodiment 5 of the invention will be described with reference to FIGS. **8A** through **8D**.

First, a positive chemically amplified resist material having the following composition is prepared:

| | |
|---|---|
| Base polymer: poly((norbomene-5-methylene-t-butylcarboxylate) (50 mol%) — (maleic anhydride) (50 mol%)) | 2 g |
| Acid generator: triphenylsulfonium triflate | 0.06 g |
| Quencher: triethanolamine | 0.002 g |
| Solvent: propylene glycol monomethyl ether acetate | 20 g |

Next, as shown in FIG. **8A**, the aforementioned chemically amplified resist material is applied on a substrate **501** so as to form a resist film **502** with a thickness of 0.35 $\mu$m.

Then, as shown in FIG. **8B**, an immersion exposure liquid **503** of water is provided between the resist film **502** and a projection lens **505**. At this point, a magnetic field with a strength (magnetic flux density) of, for example, approximately 1 x $10^{-5}$ T is applied between the resist film **503** and the projection lens **505**. Under this condition, pattern exposure is carried out by irradiating the resist film **502** through a mask (not shown) with exposing light **504** of ArF excimer laser with NA of 0.68.

After the pattern exposure, as shown in FIG. **8C**, the resist film **502** is baked with a hot plate at a temperature of 105°C for 60 seconds, and thereafter, the resultant resist film **502** is developed with a tetramethylammonium hydroxide developer in a concentration of 0.26 N. In this manner, a resist pattern **502a** made of an unexposed portion of the resist film **502** and having a line width of 0.07 $\mu$m is formed in a good shape as shown in FIG. **8D.**

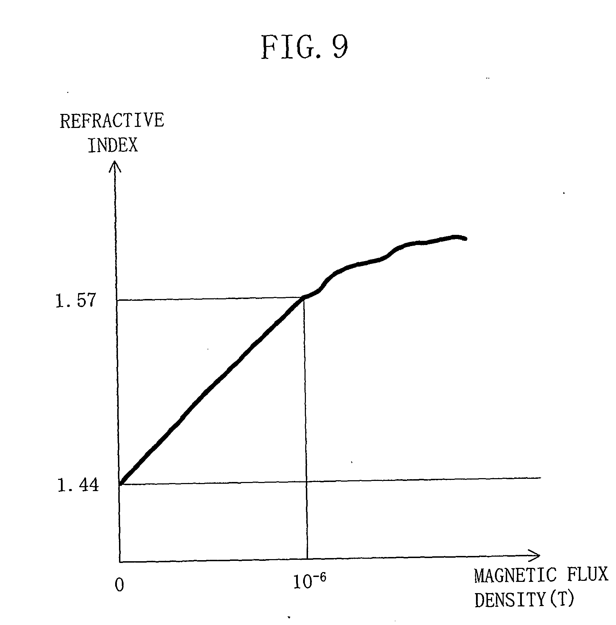

FIG. 9 shows the relationship between the strength (magnetic flux density) of the magnetic field applied to the immersion exposure liquid **503** and the refractive index of the liquid.

In this manner, according to the pattern formation method of Embodiment 5, since the immersion exposure liquid **503** is put in the magnetic field during the exposure, the polarity of the liquid **503** is higher than that of the water not put in the magnetic field. In other words, the polarization of the liquid **503** is increased, and hence, the value of the refractive index of the liquid **503** is increased. Therefore, the value of the numerical aperture of the exposure system is increased, so that the resist pattern **502a** can be formed in a good shape through the immersion lithography.

The strength of the applied magnetic field can be not less than 1 x $10^{-7}$ T and not more than 1 x $10^{-4}$ T, which does not limit the invention.

Although water is used as the immersion exposure liquid in each of Embodiments 1 through 5, perfluoropolyether can be used instead of the water.

Also, although the light source for the pattern exposure is ArF excimer laser in each of Embodiments 1 through 5, KrF excimer laser, $Xe_2$ laser, $F_2$ laser, KrAr laser or $Ar_2$ laser can be used.

As described so far, in the immersion exposure liquid and the pattern formation method of this invention, since the value of the refractive index of the immersion exposure liquid provided on a resist film can be increased, the resolution can be increased without increasing load of an exposure lens, so that a resist pattern can be formed in a good shape. Accordingly, the invention is useful as the pattern formation method or the like employing the immersion exposure for use in fabrication process or the like for semiconductor devices.

**Claims**

1. An immersion exposure liquid to be provided between a resist film formed on a substrate and an exposure lens in immersion exposure for increasing a value of a numerical aperture, comprising:

   a solvent; and
   a polar molecule having higher polarity than said solvent.

2. An immersion exposure liquid to be provided between a resist film formed on a substrate and an exposure lens in immersion exposure for increasing a value of a numerical aperture, comprising:

   a solvent; and
   a polar polymer molecule having higher polarity than said solvent.

3. An immersion exposure liquid to be provided between a resist film formed on a substrate and an exposure lens in immersion exposure for increasing a value of a numerical aperture, comprising:

a solvent; and
a nano magnetic substance.

4. The immersion exposure liquid of Claim 1,
wherein said polar molecule is a molecule having a carbonyl group, a sulfonyl group, a lactone group or activated hydrogen.

5. The immersion exposure liquid of Claim 2,
wherein said polar polymer molecule is a polymer molecule having a carbonyl group, a sulfonyl group or a lactone group.

6. The immersion exposure liquid of Claim 3,
wherein said nano magnetic substance is a magnetic disk dot with a diameter of 1 $\mu$m or less or a magnetic wire with a line width of 1 $\mu$m or less.

7. The immersion exposure liquid of Claim 1,
wherein said solvent is water or perfluoropolyether.

8. The immersion exposure liquid of Claim 2,
wherein said solvent is water or perfluoropolyether.

9. The immersion exposure liquid of Claim 3,
wherein said solvent is water or perfluoropolyether.

10. A pattern formation method comprising the steps of:

forming a resist film on a substrate;
performing pattern exposure by selectively irradiating said resist film with exposing light with a liquid provided on said resist film; and
forming a resist pattern by developing said resist film after the pattern exposure,
wherein an electric field is applied to said liquid in the step of performing pattern exposure.

11. A pattern formation method comprising the steps of:

forming a resist film on a substrate;
performing pattern exposure by selectively irradiating said resist film with exposing light with a liquid provided on said resist film; and
forming a resist pattern by developing said resist film after the pattern exposure,
wherein a magnetic field is applied to said liquid in the step of performing pattern exposure.

12. A pattern formation method comprising the steps of:

forming a resist film on a substrate;
performing pattern exposure by selectively irradiating said resist film with exposing light with a liquid, which includes a solvent and a polar molecule having higher polarity than said solvent, provided on said resist film; and
forming a resist pattern by developing said resist film after the pattern exposure.

13. A pattern formation method comprising the steps of:

forming a resist film on a substrate;
performing pattern exposure by selectively irradiating said resist film with exposing light with a liquid, which includes a solvent and a polar polymer molecule having higher polarity than said solvent, provided on said resist film; and
forming a resist pattern by developing said resist film after the pattern exposure.

14. A pattern formation method comprising the steps of:

forming a resist film on a substrate;

performing pattern exposure by selectively irradiating said resist film with exposing light with a liquid, which includes a solvent and a nano magnetic substance, provided on said resist film; and
forming a resist pattern by developing said resist film after the pattern exposure.

**15.** The pattern formation method of Claim 12,
wherein said polar molecule is a molecule having a carbonyl group, a sulfonyl group, a lactone group or activated hydrogen.

**16.** The pattern formation method of Claim 13,
wherein said polar polymer molecule is a polymer molecule having a carbonyl group, a sulfonyl group or a lactone group.

**17.** The pattern formation method of Claim 14,
wherein said nano magnetic substance is a magnetic disk dot with a diameter of 1 $\mu$m or less or a magnetic wire with a line width of 1 $\mu$m or less.

**18.** The pattern formation method of Claim 10,
wherein said solvent is water or perfluoropolyether.

**19.** The pattern formation method of Claim 10,
wherein said exposing light is KrF excimer laser, $Xe_2$ laser, ArF excimer laser, $F_2$ laser, KrAr laser or $Ar_2$ laser.

FIG. 1A

102
101

FIG. 1B

105
104
103
102
101

FIG. 1C

102
101

FIG. 1D

102a
101

# FIG. 2

FIG. 3A

202

201

FIG. 3B

205
204

203

202

201

FIG. 3C

202

201

FIG. 3D

202a

201

## FIG. 4A

## FIG. 4B

## FIG. 5A

302
301

## FIG. 5B

305
304
303
302
301

## FIG. 5C

302
301

## FIG. 5D

302a
301

## FIG. 6A

402

401

## FIG. 6B

405

404

1.0V/m

403

402

401

## FIG. 6C

402

401

## FIG. 6D

402a

401

# FIG. 7

REFRACTIVE INDEX (vertical axis)

1.61

1.44

0          1.0          STRENGTH OF ELECTRIC FIELD (V/m)

## FIG. 8A

502

501

## FIG. 8B

505

504

$10^{-5}T$

503

502

501

## FIG. 8C

502

501

## FIG. 8D

502a

501

# FIG. 9

REFRACTIVE
INDEX

1.57

1.44

0          $10^{-6}$          MAGNETIC FLUX
                               DENSITY(T)

FIG. 10A
PRIOR ART

— 2

— 1

FIG. 10B
PRIOR ART

↓    ↓    ↓    ↓    ↓    ·4

▨▨▨▨▨        ▨▨▨▨▨        5

— 3

— 2

— 1

FIG. 10C
PRIOR ART

— 2

— 1

FIG. 10D
PRIOR ART

—2a

— 1